# EUROPEAN PATENT SPECIFICATION

(11) **EP 3 024 103 B1**
(45) Date of publication and mention of the grant of the patent: **14.02.2018**
(21) Application number: 14739204.7
(22) Date of filing: 29.05.2014
(51) Int. Cl.: G01R 31/28, G01R 31/02, H02G 13/00

(54) **TESTING METHOD AND APPARATUS FOR A LIGHTNING ARRESTER**
PRÜFVERFAHREN UND -VORRICHTUNG FÜR BLITZABLEITER
PROCÉDÉ ET APPAREIL D'ESSAI POUR PARAFOUDRES

(30) Priority: 30.05.2013 ES 201330792
(43) Date of publication of application: 25.05.2016
(73) Proprietor: Aplicaciones Tecnologicas, S.A., 46980 Paterna Valencia (ES)
(72) Inventor: POMAR GARCIA, Carlos, E-46980 Paterna (Valencia) (ES); POMAR PEDREDO, Veronica, E-46980 Paterna (Valencia) (ES); POZA MARTINEZ, Moisés, E-46980 Paterna (Valencia) (ES)
(74) Representative: Carpintero Lopez, Francisco
(86) International application number: PCT/ES2014/070439
(87) International publication number: WO 2014/191605

(56) References cited:
- JP-A- 2000 321 318
- JP-A- 2004 037 169
- US-A1- 2001 038 290

## Description

### Technical Field of the Invention

The present invention corresponds to the technical field of lightning arresters with an early streamer emission (ESE) device, such as, for example, lightning arresters with a passive electronic or electric or active electronic or electric early streamer emission circuit, piezoelectric lightning arresters, lightning arresters with a special profile, and generally any lightning arrester based on the operating principle of the electro-atmospheric condenser (one or more conductor regions insulated from the ground potential).

Specifically, the present invention corresponds to the testing apparatus of said lightning arrester, the installation of the lightning arrester with an early streamer emission device and with said testing apparatus, as well as the method used for testing, which analyzes the frequency response of said early streamer emission device.

### Background of the Invention

Lightning arresters with an early streamer emission (ESE) device are a type of lightning arrester the purpose of which, like in other lightning arresters, is to attract a lightning bolt to it and ground the electrical discharge thereof, preventing damage to the area under its protection.

To that end, such lightning arrester with an early streamer emission (ESE) device emits an upward discharge that captures the lightning bolt before it strikes any other structure, and it captures said bolt at a greater distance than a conventional lightning arrester, thereby increasing the radius of action of the lightning arrester.

To assure that such lightning arrester is in perfect conditions to provide effective protection of the area, it is necessary to perform continuous or periodic control of the early streamer emission device as well as of some regions of the ESE lightning arrester itself.

Reference documents FR2848351 and WO 2004/102594 A2 can be mentioned as examples of the state of the art.

In the case of the first document FR2848351, the invention relates to a lightning arrester with an active electronic early streamer emission circuit having testing means for developing a signal indicating the operating state of the circuit based on the values measured by means of a conditioning circuit connected thereto. It further has signal emitting and receiving means and signaling means.

These emitting means emit a radio signal in a defined frequency band, and both said emitting means and receiving means are located in an independent remote test case. High voltage is used, and the test is performed every so often at a specific interval, only while the early streamer emission device is in a standby state, which occurs once time has elapsed from when electrical storm activity has ended.

In the case of the second reference document WO2004/102594 A2, the invention relates to a method for evaluating the electric parameters of the system for protecting against lightning bolts, in which at least one inspection wire electrically connected to the receiving unit is additionally mounted in the lightning arrester head, equipped with a grounding conductor. The lightning arrester testing device is activated by means of applying low voltage between the inspection wire and the grounding conductor or between inspection wires alone to control the electric energy stored in the set of capacitors.

The information obtained about the electrical parameters is transmitted by the conductors to the receiving unit which can either be mounted directly to the lightning arrester head or located at some further distance from the head and coupled electrically to its grounding conductor by means of the inspection wire.

The receiving unit is connected to a set of capacitors that store electric energy and are in turn electrically connected with an electromechanical system.

Nevertheless, the means considered in the state of the art have certain drawbacks.

Therefore, in the first document the energy storage means consist of a conventional battery, which will limit charge/discharge cycles, reducing its service life and entailing an additional waste treatment.

In the case of the second document, the problem with using electromechanical devices is that electromagnetic perturbations and switching noise, together with a small number of switching operations that will limit the service life are going to be generated. Furthermore, the fact that the receiving unit is wired with the lightning arrester limits and complicates lightning arrester accessibility and increases the process cost. It also generates deterioration of the exposed wire, which can experience induced voltage surges.

In neither case are the results stored, so they cannot be viewed later and much less extracted into any data processing device for analysis thereof.

Neither document refers to frequency analysis at any time.

In the first document, high voltage is used and the verification test is performed every certain time interval, giving 90 seconds as an embodiment. Therefore, the test is repeated every 90 seconds as long as a time limit, which can be 45 minutes or any other time limit as it can be adjusted, without electrical activity in the clouds is not exceeded. This accelerates wear of the circuit analysis means.

Furthermore, the test is performed only on a lightning arrester with an active electronic early streamer emission circuit, and does not apply to other types of lightning arresters with an early streamer emission device.

Also, in both documents the considered analysis system does not have the option of distinguishing between the different states of the lightning arrester. Therefore, the result that is offered is a lightning arrester correct result or the result that there is an error, but without determining the reason for the error, so the operator or user must go to the lightning arrester, dismount it and perform a series of verifications to detect the cause of the error and to perform the relevant repair operations.

In turn, neither of the devices described in both documents contains protective elements to protect against voltage surges at the voltage or current inlets, so they are exposed to possible potential differences that may be very high and, therefore, dangerous.

Japanese patent application JP2000321318A relates to a method and an apparatus for measuring the leaked current, capable of executing the measurement while considering the influence by the higher harmonic component of a system by application of an overall leaked current measurement method capable of dispensing with a system voltage measurement means.

Japanese patent application JP2004037169A relates to an operation monitoring apparatus of a lightning arrester to determine the deterioration state of a lightning arrester by integrating lighting strike current energy passing through a specific lightning arrester and comparing the value with a specific threshold continuously for a long time.

Finally, the US patent application US2001/038290A1 relates to energy delivery systems, and more particularly, to a system and method for determining a characteristic signature of a winding residing in a device, such as a transformer or generator.

### Description of the Invention

The problems and limitations of the background art are solved by the independent apparatus claim 1 and the independent method claim 15. Additional features are defined in the corresponding dependent claims. The testing apparatus for an early streamer emission device of a lightning arrester herein described comprises, on one hand, an emitting unit configured to be installed in a lightning arrester with power supply and energy storage means, a measurement circuit for measuring the frequency response of the early streamer emission device of the lightning arrester, a control and processing element for activating the measurement and processing the resulting frequency response, an analog-to-digital converter for converting the analog signal obtained from the test performed on the early streamer emission device before processing, a modulator circuit receiving the signal, and a transmitting antenna for transmitting the previously modulated data obtained by the measurement circuit.

The control and processing element of the emitting unit is programmed to activate performing the early streamer emission device test performed by the testing module every configurable time interval t1. It is also responsible for keeping the emitting unit in a standby state during configurable time intervals t2, t2 being less than t1, and to activate sending the result of each test that is performed every time t1, as well as repeatedly sending the last test performed every time t2.

These times t1 and t2 are either software-configurable or configurable by means of timing of the elements.

The power supply means of the emitting unit can be based on renewable power sources, such as a solar panel or the like, for example, and the storage means preferably do not have a limitation on charge/discharge cycles and do not require waste treatment, although conventional power supply means such as any type of battery can be used, introducing the aforementioned limitations.

This testing apparatus for an early streamer emission device of a lightning arrester described herein performs a frequency test. It consists of the control and processing element generating a set of pulses with a time having a configurable value that attacks the early streamer emission device of the lightning arrester. This early streamer emission device provides a voltage and frequency response that is related to the configuration and state of the lightning arrester.

It can comprise as an additional test evaluation of the temporal response of the circuit in the event of transient, alternate or continuous signals, whether they are periodic or not. Therefore, in the event of a pulse or set of pulses applying signals of any of the mentioned types, the response of the device after a time also having a configurable value is evaluated, measuring the evolution of said previously introduced set of pulses. An analog signal measured by the measurement circuit, transformed into digital by means of the analog-to-digital converter and processed by means of the control and processing element using mathematical methods that allow obtaining the response to transient phenomena of the lightning arrester with an early streamer emission device, is obtained.

On the other hand, the testing apparatus has a wireless receiving unit, identification means for identifying the different states of the lightning arrester, an internal memory that allows storing data of successive tests performed and an external connector for extracting data into a data processing device.

The identification means for identifying the different states of the lightning arrester of this receiving unit can consist of pilot lights, preferably LED-type pilot lights, although any way of displaying the result is optimal.

This receiving unit also comprises an on/off switch, power supply and energy storage means, a control and processing element, a DC-DC converter reducing the voltage of the storage means connected to the control and processing element, a circuit breaker of the power supply system, an integrated antenna for receiving data, a demodulation element for demodulating said data and a result display screen.

This receiving unit allows displaying previous test data stored in the internal memory thereof and comprises a push button for activating this function. Optionally, an individual identification system can be included for each lightning arrester which is sent to the receiving unit by means of a single code to help with maintenance and follow-up operations, as well as to enable identifying the origin of the data in installations with more than one lightning arrester with an early streamer emission device.

In turn, the emitting unit can comprise protective elements to protect against voltage surges in each connection that may be affected by such surges.

This apparatus complies with all aspects of the UNE 21186:2011 standard.

In addition to the testing apparatus for an early streamer emission device of a lightning arrester, the present specification describes an installation of a lightning arrester with a testing apparatus where the testing apparatus is as previously defined.

Said installation of a lightning arrester is such that the emitting unit of the apparatus is suitable for being arranged in the lightning arrester, where the casing thereof can have any configuration, being either frusto-pyramidal, flared, spherical, cap-shaped, cylindrical, or it can have any other configuration that elements characteristic of a lightning arrester have, such as tip and shaft for example.

The emitting unit of the testing apparatus can be integrated in the lightning arrester or it can be located outside same.

In this latter case, said emitting unit comprises a casing connected to the grounded portion of the lightning arrester. Said casing has a first opening for emitting the RF signal and a second opening for connecting the measurement circuit for measuring frequency response in the emitting unit and the early streamer emission device of the lightning arrester by wire.

Said connection of the casing of the emitting unit with the lightning arrester can comprise a part for adapting and orienting the casing.

Finally, in addition to the testing apparatus for an early streamer emission device of a lightning arrester and the installation of a lightning arrester with said apparatus, there is described in this specification a testing method for a lightning arrester with an early streamer emission device by means of the described testing apparatus and for installations of a lightning arrester with a testing apparatus such as that previously defined.

This method comprises a series of steps that begin by activating the control and processing element.

Then testing of the early streamer emission device of the lightning arrester is performed by the emitting unit. Said testing is done every time a certain time interval t1 is exceeded or, in the event that a stoppage in the supply provided by the power supply means of the emitting unit is detected.

For the purpose of reducing energy consumption, this emitting unit is usually in a standby state for a certain time t2, t2 being less than t1.

Next, the data resulting from testing and characteristic of the lightning arrester and, where appropriate, the identification code of the lightning arrester are sent to the receiving unit. They are sent every time testing is performed, which is every time that time period t1 is exceeded or in the event of detecting a stoppage in the supply.

On the other hand, every time the standby state is interrupted after time t2 has elapsed, the repeated data of the last test performed is sent. A specific test is sent repeatedly every time t2 until time t1 is exceeded, where a new test is performed, said test being the one that starts to be sent after that moment repeatedly with every time t2 until again exceeding time t1.

To obtain the result of the data, the receiving unit must be activated, data being received from the emitting unit in a time less than or equal to t2. This activation is performed every time either testing or repeated data is sent.

The received data comprises at least showing the test result, distinguishing the state of the lightning arrester, which can be correct, short circuited or incorrect frequency and/or voltage response of the early streamer emission device. Furthermore, other useful data such as the reference of the lightning arrester or the characteristics thereof can be added.

When activating the receiving unit, a wait time counter with a configurable time limit t3 can be activated. This value of time t3 is greater than the value of time interval t2, such that if time t3 is exceeded without having received any data frame, an error signal is generated, the same identifying that the receiver is outside the emitting range of the emitting unit, there being insufficient energy for sending data, or is impaired due to any other reason.

In contrast, if time limit t3 is not exceeded, there are two possibilities; on one hand, the received signal is correct, in which case the shown result determines the state of the lightning arrester, which can be correct, short circuited or incorrect frequency and/or voltage response of the early streamer emission device, and on the other hand the received signal may not be the correct signal, which in this case allows identifying whether there is a data receiving error.

Finally, the received data is stored for displaying at a later time.

With the testing apparatus for an early streamer emission device of a lightning arrester, the installation of a lightning arrester with said testing apparatus and the testing method by means of said apparatus herein proposed, a significant improvement of the state of the art is obtained.

This is because the testing apparatus has power supply and energy storage means that do not have any limitation with respect to charge/discharge cycles, nor does it use any toxic substances or chemical reactions to obtain energy, so maintenance and waste treatment costs decline, although common power supply means such as batteries can be used, resulting in the aforementioned drawbacks. Furthermore, the receiving unit is wireless, so operator or user accessibility limitations existing in wired devices in the state of the art are eliminated, and in turn, risks resulting from exposed wires being more likely to deteriorate in addition to being subjected to induced voltage surges are no longer an issue.

A testing method is proposed that is very effective while at the same time safe because low-voltage frequency analysis allows identifying the overall state of the ESE, because each element that is part of the lightning arrester contributes to the frequency response of the arrester. Furthermore, since it is done in a low voltage regimen, there is no problem associated with the safety of people or property.

Frequency and temporal testing can be combined, analyzing the response to transient phenomena of the device, to offer a more comprehensive analysis if needed. Furthermore, the possibility of electronically identifying each terminal allows greatly simplifying inspection and maintenance tasks by operators or users.

This testing apparatus does not have any electromechanical component, so possible noises due to relay switching are also avoided. Furthermore, it has protective elements to protect against voltage surges for enhanced apparatus protection.

The proposed apparatus also has a data storage memory, as well as the possibility of extracting the data into a computer or any other data processing device for data analysis. Said data can also be displayed on the screen of the receiving unit.

Another advantage is that when showing the results, the apparatus does not merely indicate that there is an error, but distinguishes the possible causes of that error, determining the lightning arrester's situation.

This apparatus in turn minimizes energy consumption as it reduces the number of tests performed. So as a result of the standby state in which the emitting unit is kept and the fact that the tests are performed every certain time greater than the standby time, a signal is received every time a standby state ends, confirming that the apparatus works, but a new test is not performed until a certain time at which it is considered necessary. Consequently, consumption declines, and the components that are part of the testing apparatus and the early streamer emission device are strictly controlled.

This testing apparatus is valid for any lightning arrester with an early streamer emission device, regardless of if this device is an electric or electronic, passive or active early streamer emission circuit, a piezoelectric device or if it has a special profile. Any lightning arrester having a floating element can be tested by this system.

Furthermore, this apparatus is also valid for a lightning arrester with both an active and a passive electronic early streamer emission circuit.

The installation of a lightning arrester with a testing apparatus offers a range of possible apparatus placement sites, which offers greater possibilities because the emitting unit can be integrated in the lightning arrester or be arranged outside same, helping with repair and maintenance tasks when needed.

Many advantages are also obtained with the testing method for a lightning arrester with an early streamer emission device, by means of a testing apparatus like the one described, because it is a completely autonomous testing method by means of frequency analysis of the early streamer emission device in order to verify if the equipment is working properly.

This method allows distinguishing the possible states of the lightning arrester, reducing operator or user actuation time because if there is an error, the cause is determined so it can therefore be corrected sooner.

Therefore, a much safer and less expensive testing method that is highly effective, easy to use, comfortable for the operator or user and provides the specific result of the state of the lightning arrester is achieved.

### Brief Description of the Drawings

To help better understand the features of the invention according to a preferred practical embodiment thereof, a set of drawings is attached as an integral part of said description, in which the following is depicted with an illustrative and non-limiting character:
Figure 1 shows a flowchart of the operating procedure of the emitting unit.
Figure 2 shows a flowchart of the operating procedure of the receiving unit.
Figure 3 shows a block diagram of the electronic circuits of the emitting unit.
Figure 4 shows a block diagram of the electronic circuits of the receiving unit.
Figure 5 shows a perspective view of an emitting unit located outside the lightning arrester for a first preferred embodiment of the invention.
Figure 6 shows a plan view of a receiving unit for a first and a second preferred embodiment of the invention.
Figure 7 shows a front view of an emitting unit located inside the lightning arrester for a second preferred embodiment of the invention.

### Detailed Description of a Preferred Embodiment of the Invention

In view of the attached drawings, it can be seen that in a first preferred embodiment of the invention, the testing apparatus for an early streamer emission device of a lightning arrester 1 herein proposed consists of an emitting unit 2 configured to be installed in a lightning arrester 1, and a receiving unit 3.

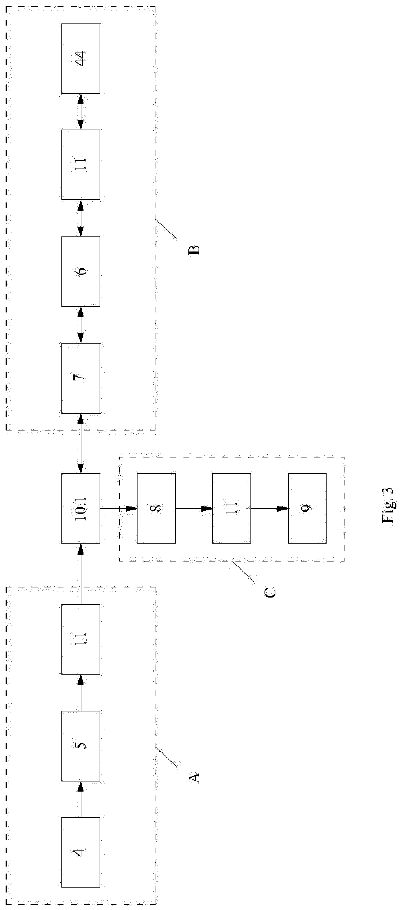

As can be seen in Figure 3, the emitting unit 2 comprises power supply means 4 which, in this first preferred embodiment of the invention, consist of a solar panel and energy storage means 5 for storing the energy obtained by said panel complying with the condition of not limiting the number of charge/discharge cycles and not requiring waste treatment, both being part of the power supply block A.

It has a second measurement block B, consisting of a measurement circuit 6 for measuring the frequency response of the lightning arrester, and an analog-to-digital converter 7 to convert this response before being processed, and a third emitting block C comprising a modulator circuit 8 receiving the signal, modulating it and sending it through a transmitting antenna 9.

The emitting unit 2 in turn comprises a control and processing element 10.1 for activating the testing module 44 and processing the resulting digitalized frequency response. Said control and processing element 10.1 is programmed to activate performing the test repeatedly every time a certain time period t1 has elapsed, which is 24h in this first preferred embodiment of the invention. The emitting unit 2 is also in a standby state 26 that will last also a certain time period t2 provided that t2 is less than t1. Finally, the control and processing element 10.1 activates sending the test result every time a new test is performed as time t1 has elapsed, and it actives repeatedly sending this same result every time t2 the standby state ends.

In this preferred embodiment of the invention, the testing apparatus comprises an individual identification system for individually identifying each lightning arrester, such that when the control and processing element 10.1 sends the test result, it also activates sending the identification of the equipment to the receiving unit. In the case of repeatedly sending the previous test result, the identification of the equipment to which the data corresponds will be sent simultaneously.

In this preferred embodiment of the invention, both t1 and t2 are software-configurable.

As seen in Figure 3, in each connection the emitting unit 2 has a protective element 11 to protect against voltage surges.

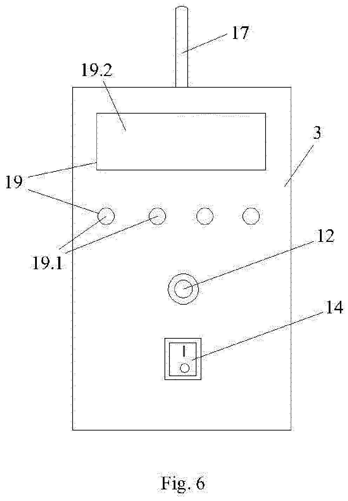

The receiving unit 3 is wireless and comprises identification means 19 for identifying the different states of the lightning arrester, an internal memory that allows storing data with respect to the tests being performed, and an external connector that will allow extracting said test data into a data processing device. As can be seen in Figure 6, the receiving unit has a push button 12 to enable displaying said previous test data in said unit.

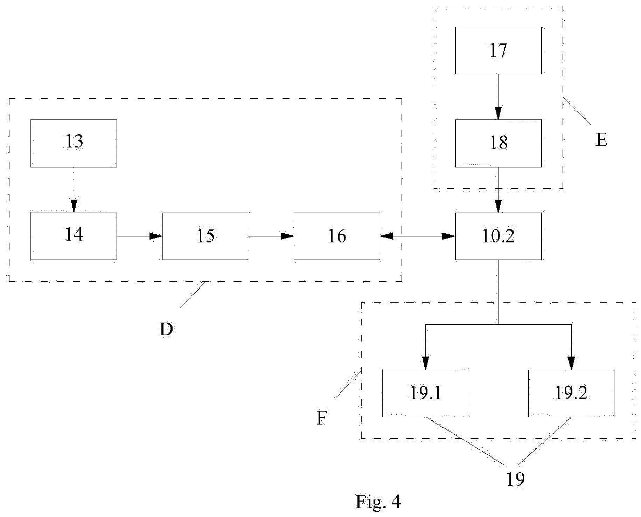

As shown in Figure 4, the receiving unit 3 consists of a power supply block D incorporating said power supply and energy storage means 13, an on/off switch 14 for the receiving unit 3, an optional DC-DC converter 15 and a circuit breaker 16 in case the unit has not been switched off manually by an operator for a considerable length of time.

It in turn has a receiving block E consisting of an integrated antenna 17 for receiving data and a demodulation element 18 for demodulating said data.

Finally, it comprises a display block F consisting of the identification means 19 for identifying the different states of the lightning arrester 1, which in this first preferred embodiment of the invention consist of LED-type pilot lights 19.1, and a result display screen 19.2 for displaying the result and, optionally, the identification of the terminal.

The receiving unit 3 also comprises a control and processing element 10.2 that interrelates these actuation blocks D, E, F.

This apparatus complies with the condition of being able to withstand at least three current pulses having an amplitude of 100 kA with a 10/350 µs wave, and with aspects of the UNE 21186:2011 standard.

In this preferred embodiment of the invention, in addition to the frequency test, an additional test evaluating the temporal response of the circuit to each pulse or set of pulses is performed, obtaining the response of the circuit after a time having a configurable value.

This specification also describes an installation of a lightning arrester 1 with a testing apparatus which is as defined.

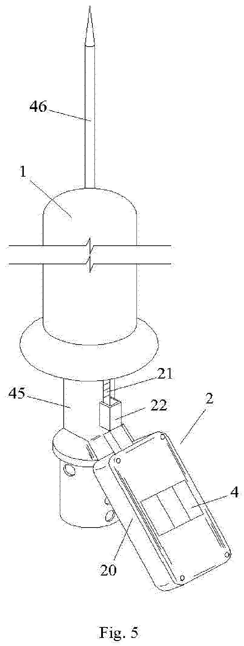

As can be seen in Figure 5, in this first preferred embodiment of the invention the lightning arrester 1 has a configuration in the form of a casing in which the early streamer emission device, which is not depicted in the drawings, with the corresponding tip 46 and the corresponding shaft 45, is arranged.

Said Figure 5 shows that in this preferred embodiment of the invention, the emitting unit 2 of the testing apparatus for an early streamer emission device of a lightning arrester 1 is installed outside the lightning arrester 1.

Therefore, the emitting unit 2 comprises a casing 20 connected to the lightning arrester 1, in the grounded portion 45 thereof, to thus prevent harmful potential differences and to shield the equipment.

The casing 20 of this emitting unit 2 has a first opening for emitting the signal, and a second opening for connecting the equivalent measurement circuit 6 for measuring the frequency response of the early streamer emission device in the emitting unit 2 with the early streamer emission device of the lightning arrester 1 by wire 21.

In this preferred embodiment of the invention and as seen in Figure 5, the connection of the emitting unit 2 with the lightning arrester 1 has a part 22 for adapting and orienting the casing 20. Therefore, it enables arranging the casing 20 such that the solar panel is in the desired position, preferably that position in which it receives greatest mean exposure to sunlight throughout the entire year.

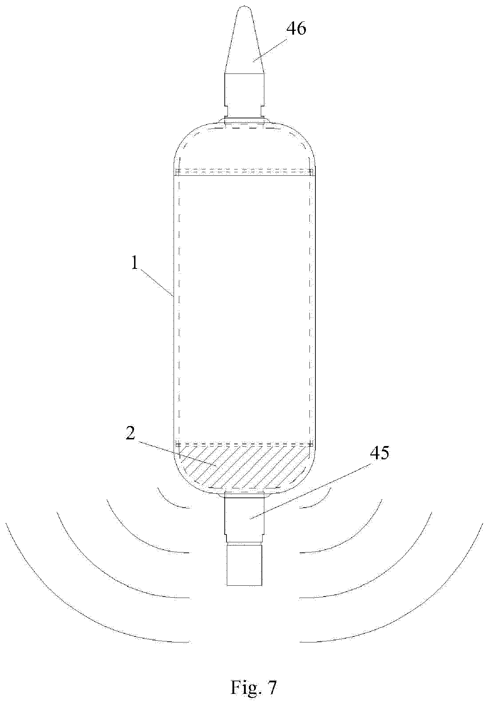

Figure 7 shows the lightning arrester for a second embodiment of the invention in which the testing apparatus for an early streamer emission device of a lightning arrester is similar to that described for the first embodiment of the invention, but in which the installation of a lightning arrester comprises the emitting unit of the apparatus integrated in the casing of the lightning arrester.

As shown in said Figure 7, in this second preferred embodiment of the invention, the lightning arrester 1 also has a body in the form of a casing in which the early streamer emission device, which is not depicted, is housed, with the corresponding tip 46 and the corresponding shaft 45, with the particularity that the emitting unit 2 is integrated in the body of the lightning arrester 1. In this case, the previously described casing 20 is not needed.

This specification in turn describes for both preferred embodiments of the invention a testing method for a lightning arrester 1 with an early streamer emission device, according to the testing apparatus and the installation of a lightning arrester 1 with said apparatus defined herein.

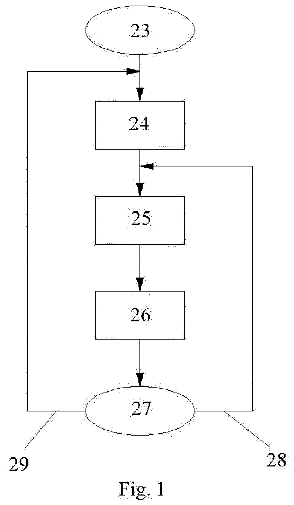

This testing method therefore consists of the following steps:
As seen in Figure 1, first the control and processing element (10.1) is activated 23.
Secondly, the early streamer emission device of the lightning arrester 1 is tested 24 every certain time interval t1, which is 24 hours in this preferred embodiment of the invention.

Then the data obtained from testing along with the identification data of the lightning arrester is sent 25 wirelessly to the receiving unit 3.

Once the data is sent 25, the emitting unit 2 enters a standby state 26 during a certain configurable time t2 according to needs or constraints, and in this embodiment of the invention such time t2 is 90 seconds, which complies with the condition of being less than the value of t1.

The next step occurs once a 90-second time interval t2 has elapsed, and therefore the standby period of the emitting unit has ended. At that time, the control and processing element performs 27 an analysis to determine if a 24-hour time period t1 has elapsed. If it has not, the same data resulting from the previous test that was performed is sent 28 repeatedly every 90-second time t2 until a 24-hour time t1 has elapsed.

If, however, the control and processing element (10.1) analyzes if the time elapsed is greater than t1, which is 24 hours in this case, and the result is that it has elapsed, it activates 44 the testing module to perform 29 another test on the early streamer emission device of the lightning arrester 1.

Activating the performance 29 of a new test is also done if the existence of a stoppage in the power supply means of the emitting unit is detected.

Then the emitting unit returns to standby 26, and the process is repeated.

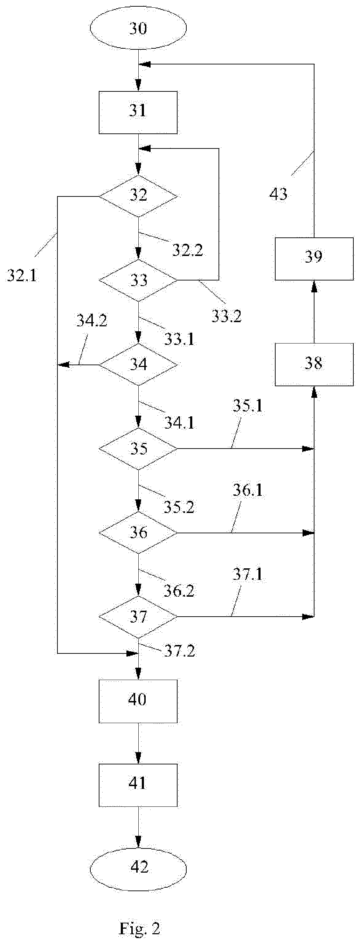

Figure 2 shows the operating procedure of the receiving unit 3. This process starts with activation 30 of the receiving unit 3 every time the test data is sent.

From the moment of activation 30, the receiving unit 3 is waiting to receive a data frame compatible with the communication standard used. When this unit starts to operate, a wait time counter 31, with a certain time limit t3 which is 2 minutes in this preferred embodiment, complying with being greater than the 90-second standby time t2, is activated.

This counter will allow the receiving unit 3 to verify if a data frame was received within the maximum emission/reception time configured in both devices.

To that end, an analysis is performed to determine if the wait time is exceeded 32. If it is determined from the analysis that the wait time has been exceeded 32.1 without obtaining data, the emitting unit 3 determines that there is an error 40 because it is outside the range of the emitting equipment or because the emitter is not working properly and shows this result 41 to the operator or user, ending the method 42, so that the operator or user can repair the problem.

If the wait time is not exceeded 32.2, the receiver continues to wait for the data frame and analyzes whether or not it receives it 33. If data is not received 33.2, the wait continues.

If, however, a compatible data frame reaches 33.1 the receiver 3 before the wait time is exceeded, the latter verifies 34 if said data is consistent with the possible test results.

If the data is not compatible 34.2, the emitting unit determines that there is an error 40 because the received data is not consistent with the possible test results and shows this result 41 to the operator or user, ending the process 42 so that the operator or user can repair the problem. Therefore, it distinguishes whether the error is due to the receiver not being within the range of the emitter 32.1, or if the error is due to receiving erroneous data 34.2.

In the event that the received data is consistent 34.1 with the possible test results, the receiving unit 3 analyzes whether the lightning arrester 1 works properly 35. If the result is in fact affirmative 35.1, said result is shown 38 to the operator or user and the result is stored 39, returning to the beginning 43 of the method.

If the result determines that the state of the lightning arrester is not correct 35.2, the possible existence of a short circuit is analyzed 36. In this case, like in the previous case, if the result determines that there is a short circuit 36.1, the result is shown 38 to the operator or user and said result is stored 39, starting the process 43 again, but if the obtained result indicates that there is no short circuit 36.2, it then analyzes if perhaps the frequency response of the early streamer emission device is not correct 37.

If it is indeed obtained that it is not correct 37.1, this result is shown 38 to the operator or user, and the result is stored 39, the process starting again 43, whereas if that is not the problem either, the existence of an error is determined 40 and the result is shown 41 to the operator or user, ending the process 42 to rectify the existing error.

The results are stored 38 in the internal memory of the receiving unit to enable displaying them again on the result screen 19.2 or to extract them into an external data processing device, such as a computer.

Significant improvements with respect to the state of the art are achieved with the testing apparatus for an early streamer emission device of a lightning arrester, the installation of a lightning arrester with said apparatus and the testing method by means of this apparatus herein described.

Therefore, a test is obtained that allows providing, in a safe manner with very low consumption, a very simple and effective frequency and/or temporal test for analyzing transient phenomena.

Furthermore, with this testing apparatus and as a result its power supply and energy storage means, there is no limitation on charge/discharge cycles and it does not require waste treatment.

Therefore, costs decline and furthermore, since it is an apparatus with a wireless receiving unit, manageability thereof by operators or users is facilitated, eliminating accessibility limits as well as increasing the safety thereof.

The testing apparatus further offers the possibility of saving the obtained results in an internal memory for displaying same at a later time in the receiving unit itself or being able to download such results by means of the external connector into a data processing device where much more comprehensive studies of the results obtained from the early streamer emission device can be performed.

This apparatus also distinguishes the different reasons behind an error in a test result, so it is much more efficient because the operator or user quickly finds out where the problem is and can act right away to fix it. Furthermore, this is all done with a small number of tests, so consumption of the testing apparatus declines, in addition to the wear of elements involved in the test also declining.

The installation of a lightning arrester with this testing apparatus in turn allows the option of the emitting unit being located inside or outside the casing of the lightning arrester, according to the specific characteristics of each case.

The testing method for a lightning arrester with such apparatus and installation is also entirely autonomous and allows the testing apparatus to distinguish the different states of the early streamer emission device of a specific lightning arrester.

Finally, the emitter may also send the reference of the lightning arrester being tested, in addition to the test, allowing univocal identification of the lightning arrester and preventing the possibility of confusing different lightning arresters.

It is therefore a simple and comfortable method that largely facilitates the operator's or user's work as it allows the testing apparatus to offer the most specific result possible.

## Claims

1. Testing apparatus for an early streamer emission device of a lightning arrester (1), the testing apparatus comprising:
- an emitting unit (2) configured to be installed in a lightning arrester (1), incorporating power supply means (4) and energy storage means (5), and
- a wireless receiving unit (3) comprising a receiving antenna (17), and a signal demodulator (18) to demodulate the signal obtained by the same, **characterized in that** the emitting unit (2) further comprises a control and processing element (10.1) configured to generate a set of pulses with a time having a configurable value that attacks the early streamer emission device of the lightning arrester and also configured to activate said early streamer emission device and process the resulting frequency response, a measurement circuit (6) configured to measure the frequency response of the early streamer emission device of the lightning arrester, a testing module (44) configured to be activated by the control and processing element (10.1), an analog-to-digital converter (7) configured to convert the analog signal obtained from the test performed on the early streamer emission device before processing, a modulator circuit (8) configured to modulate the signal and a transmitting antenna (9) configured to transmit the previously modulated processed data;
- wherein the control and processing element (10.1) is programmed to activate the early streamer emission device test, performed by the testing module (44), every configurable time interval t1, keeping the emitting unit (2) in a standby state (26) during a configurable time interval t2, wherein t2 being less than t1, and to activate the sending of a result of a new test every time t1 and the sending of the repeated result of the last test performed every time t2;
- and wherein the receiving unit (3) further comprises identification means (19) configured to identify the different states of the lightning arrester, an internal memory adapted to allow storing the data of successive tests performed, and an external connector adapted to extract said data into a data processing device.

2. The testing apparatus according to claim 1, wherein the times t1 and t2 are software-configurable.

3. The testing apparatus according to claim 1, wherein the times t1 and t2 are configurable by configuring the timing of the elements of the testing apparatus.

4. The testing apparatus according to any of the preceding claims, wherein the testing apparatus is configured to support at least three current pulses having an amplitude of 100 kA with a 10/350 µs wave.

5. The testing apparatus according to any of the preceding claims, wherein the receiving unit (3) comprises an on/off switch (14), power supply and energy storage means (13), a control and processing element (10.2), an optional DC-DC converter (15) configured to reduce the voltage of the storage means (13) connected to the control and processing element (10.2), a circuit breaker (16) and a result display screen (19.2).

6. The testing apparatus according to any of the preceding claims, wherein the receiving unit (3) allows displaying previous test data and comprises a push button (12) for activating this option.

7. The testing apparatus according to any of the preceding claims further comprising an identification system configured to identify the lightning arrester in each data frame to help with lightning arrester control, follow-up and maintenance tasks.

8. The testing apparatus according to any of the preceding claims, wherein, in addition to frequency analysis, the testing apparatus is configured to perform temporal analysis of circuit response to transient, alternate or continuous signals, whether they are periodic or not.

9. The testing apparatus according to any of the preceding claims, wherein the emitting unit (2) comprises protective elements (11) configured to protect against voltage surges in each connection that may receive such surges.

10. Installation of a lightning arrester (1) with the testing apparatus defined in claims 1 to 9, wherein the emitting unit (2) of the testing apparatus is suitable for being arranged in the lightning arrester (1), and the emitting unit (2) comprises a casing (20) which is frusto-pyramidal shaped, flared, cap-shaped, cylindrical, spherical or have any other shape that elements characteristic of a lightning arrester have, such as tip and shaft (45).

11. The installation according to claim 10, wherein the emitting unit (2) of the testing apparatus is integrated in the casing of the lightning arrester (1).

12. The installation according to claim 10, wherein the emitting unit (2) of the testing apparatus is located outside the casing of the lightning arrester (1).

13. The installation according to claim 11, wherein the casing (20) is connected to the grounded portion (45) of the lightning arrester (1), and it has a first opening for emitting the signal and a second opening for connecting the measurement circuit for measuring frequency response in the emitting unit (2) and the early streamer emission device of the lightning arrester (1) by a wire (21).

14. The installation according to claim 11, wherein the connection of the casing (20) of the emitting unit (2) comprises a part (22) configured for adapting and orienting the same.

15. Testing method, using the testing apparatus defined in claims 1 to 9, for testing a lightning arrester (1) with and early streamer emission device and for testing the installation of a lightning arrester as defined in claims 10 to 14, the testing method comprising:
- activating (23) the control and processing element (10.1);
- testing (24), by the emitting unit (2), the early streamer emission device of the lightning arrester (1) every time a certain time interval t1 is exceeded, or if a lack of supply in the power supply means (4) thereof is detected, said emitting unit (2) being in a standby state (26) during certain time intervals t2, t2 being less than t1;
- sending (25) data resulting from testing and characteristics of the lightning arrester (1) to the receiving unit (3);
- repeatedly sending (28) said data every time interval t2, when the standby state (26) is interrupted, until time period t1 is exceeded;
- activating (30) the receiving unit (3) and receiving data through said unit (3) every time testing data or repeated data is sent, comprising the activation (31) of a wait time counter with a configurable time limit t3, t3 being greater than t2;
- showing (38) the result, distinguishing the state of the lightning arrester as correct, short circuited, or incorrect frequency response of the early streamer emission device, and;
- storing (39) data for displaying at a later time.

16. The testing method according to claim 15, wherein if the time limit t3 is exceeded without receiving data, an error signal (40) is generated, indicating that the receiver is outside the emitting range of the emitting unit (2), there being insufficient energy for sending data, or is impaired due to any other reason.

17. The testing method according to claim 15, wherein if the time limit t3 is not exceeded and the signal received is correct, the shown result (38) distinguishes if the lightning arrester is correct or short circuited, or if it has an incorrect frequency response of the early streamer emission device.

18. The testing method according to claim 15, wherein if the time limit t3 is not exceeded and the signal received is not correct, it allows identifying whether there is a data receiving error.

## Patentansprüche

1. Prüfvorrichtung für eine Early Streamer Emission (EME)-Einrichtung eines Blitzableiters (1), wobei die Prüfvorrichtung umfasst:
- eine emittierende Einheit (2), die konfiguriert ist, um in einem Blitzableiter (1) installiert zu werden, wobei Stromversorgungsmittel (4) und Energiespeichermittel (5) einbezogen sind, und
- eine drahtlose Empfangseinrichtung (3), die eine Empfangsantenne (17) und einen Signaldemodulator (18) umfasst, um das durch dieselbe erhaltene Signal zu demodulieren,
**dadurch gekennzeichnet, dass** die emittierende Einheit (2) des Weiteren
ein Steuerungs- und Verarbeitungselement (10.1), das konfiguriert ist, um einen Satz von Impulsen mit einer Zeit zu generieren, welche einen konfigurierbaren Wert aufweist, der die ESE-Einrichtung des Blitzableiters angreift, und auch konfiguriert ist, um die ESE-Einrichtung zu aktivieren und die resultierende Frequenzantwort zu verarbeiten,
eine Messschaltung (6), die konfiguriert ist, um die Frequenzantwort der ESE-Einrichtung des Blitzableiters zu messen,
ein Prüfmodul (44), das konfiguriert ist, um durch das Steuerungs- und Verarbeitungselement (10.1) aktiviert zu werden,
einen Analog/Digital-Wandler (7), der konfiguriert ist, um das aus der Prüfung, die mit der ESE-Einrichtung vor der Verarbeitung durchgeführt wurde, erhaltene Analogsignal zu wandeln,
eine Modulatorschaltung (8), die konfiguriert ist, um das Signal zu modulieren, und
eine Übertragungsantenne (9), die konfiguriert ist, um die zuvor modulierten verarbeiteten Daten zu übertragen, aufweist;
- wobei
das Steuerungs- und Verarbeitungselement (10.1) programmiert ist, um die Prüfung der ESE-Einrichtung, die durch das Prüfmodul (44) durchgeführt wird, an jedem konfigurierbaren Zeitintervall t1 zu aktivieren, wobei die emittierende Einheit (2) während eines konfigurierbaren Zeitintervalls t2 in einem Standby-Zustand (Bereitschaftszustand) (26) gehalten wird, wobei t2 kleiner als t1 ist, und um das Senden eines Ergebnisses einer neuen Prüfung zu jeder Zeit t1 und das Senden des wiederholten Ergebnisses der letzten durchgeführten Prüfung zu jeder Zeit t2 zu aktivieren;
- und wobei die Empfangseinheit (3) des Weiteren Identifikationsmittel (19), die konfiguriert sind, um die unterschiedlichen Zustände des Blitzableiters zu identifizieren, einen internen Arbeitsspeicher, der vorgesehen ist, um Speichern der Daten von aufeinander folgenden durchgeführten Prüfungen zu ermöglichen, und ein externes Anschlussstück umfasst, das vorgesehen ist, um die Daten in eine Datenverarbeitungseinrichtung zu extrahieren.

2. Prüfvorrichtung nach Anspruch 1, wobei die Zeiten t1 und t2 softwareseitig konfigurierbar sind.

3. Prüfvorrichtung nach Anspruch 1, wobei die Zeiten t1 und t2 konfigurierbar sind, indem die Zeitwahl der Elemente der Prüfvorrichtung konfiguriert wird.

4. Prüfvorrichtung nach einem der vorhergehenden Ansprüche, wobei die Prüfvorrichtung konfiguriert ist, um mindestens drei Stromimpulse mit einer Amplitude von 100 kA mit einer 10/350 µs-Welle zu unterstützen.

5. Prüfvorrichtung nach einem der vorhergehenden Ansprüche, wobei die Empfangseinheit (3) einen ein/aus-Schalter (14), Stromversorgungs- und Energiespeichermittel (13), ein Steuerungs- und Verarbeitungselement (10.2), einen optionalen DC-DC-Wandler (15), der konfiguriert ist, um die Spannung des Speichermittels (13) zu reduzieren, das an das Steuerungs- und Verarbeitungselement (10.2) angeschlossen ist, einen Stromkreisunterbrecher (16) und einen Ergebnisanzeigebildschirm (19.2) umfasst.

6. Prüfvorrichtung nach einem der vorhergehenden Ansprüche, wobei die Empfangseinheit (3) das Anzeigen vorhergehender Prüfdaten zulässt und eine Drucktaste (12) zum Aktivieren dieser Option umfasst.

7. Prüfvorrichtung nach einem der vorhergehenden Ansprüche, ferner umfassend ein Identifikationssystem, das konfiguriert ist, um die Blitzableiter in jedem Datenrahmen zu identifizieren, um Steuerungs-, Nachbeobachtungs- und Wartungsaufgaben des Blitzableiters zu unterstützen.

8. Prüfvorrichtung nach einem der vorhergehenden Ansprüche, wobei die Prüfvorrichtung zusätzlich zu der Frequenzanalyse konfiguriert ist, um zeitliche Analyse der Schaltkreisreaktion auf transiente, alternierende oder kontinuierliche Signale durchzuführen, die periodisch sein können oder nicht.

9. Prüfvorrichtung nach einem der vorhergehenden Ansprüche, wobei die emittierende Einheit (2) Schutzelemente (11) umfasst, die konfiguriert sind, um vor Spannungsstößen in jedem Anschluss zu schützen, der derartige Stöße empfangen kann.

10. Installation eines Blitzableiters (1) mit der in den Ansprüchen 1 bis 9 definierten Prüfvorrichtung, wobei die emittierende Einheit (2) der Prüfvorrichtung geeignet ist, um in dem Blitzableiter (1) angeordnet zu werden, und die emittierende Einheit (2) ein Gehäuse (20) umfasst, das pyramidenstumpfförmig, aufgeweitet, kappenförmig, zylindrisch, kugelförmig ist oder jede beliebige andere Form aufweist, die Elemente aufweisen, die für einen Blitzableiter charakteristisch sind, wie eine Spitze und einen Schaft (45)

11. Installation nach Anspruch 10, wobei die emittierende Einheit (2) der Prüfvorrichtung in das Gehäuse des Blitzableiters (1) integriert ist.

12. Installation nach Anspruch 10, wobei die emittierende Einheit (2) der Prüfvorrichtung sich außerhalb des Gehäuses des Blitzableiters (1) befindet.

13. Installation nach Anspruch 11, wobei das Gehäuse (20) an den geerdeten Abschnitt (45) des Blitzableiters (1) angeschlossen ist und eine erste Öffnung zum Emittieren des Signals und eine zweite Öffnung zum Verbinden der Messschaltung zur Messung der Frequenzantwort in der emittierenden Einheit (2) und der ESE-Einrichtung des Blitzableiters (1) mittels eines Drahtes (21) aufweist.

14. Installation nach Anspruch 11, wobei der Anschluss des Gehäuses (20) der emittierenden Einheit (2) einen Teil (22) umfasst, der konfiguriert ist, um dieses anzupassen und zu orientieren.

15. Prüfverfahren, welches die in den Ansprüchen 1 bis 9 definierte Prüfvorrichtung verwendet, um einen Blitzableiter (1) mit einer ESE-Einrichtung zu prüfen, und um die Installation eines Blitzableiters wie in den Ansprüchen 10 bis 14 definiert zu prüfen, wobei das Prüfverfahren umfasst:
- Aktivieren (23) des Steuerungs- und Verarbeitungselements (10.1);
- Prüfen (24) der ESE-Einrichtung des Blitzableiters (1) durch die emittierende Einheit (2) jedes Mal, wenn ein bestimmtes Zeitintervall t1 überschritten wird, oder wenn eine fehlende Versorgung in ihrem Stromversorgungsmittel (4) erkannt wird, wobei sich die emittierende Einheit (2) während bestimmter Zeitintervalle t2 in einem Standby-Zustand (26) befindet, wobei t2 kleiner als t1 ist;
- Senden (25) von Daten, die aus Prüfungen resultieren, und Charakteristika des Blitzableiters (1) zu der Empfangseinheit (3);
- wiederholtes Senden (28) der Daten zu jedem Zeitintervall t2, wenn der Standby-Zustand (26) unterbrochen wird, bis die Zeitperiode t1 überschritten ist;
- Aktivieren (30) der Empfangseinheit (3) und Empfangen von Daten durch diese Einheit (3) jedes Mal, wenn Prüfdaten oder wiederholte Daten gesendet werden, umfassend die Aktivierung (31) eines Wartezeitzählers mit einer konfigurierbaren Zeitgrenze t3, wobei t3 größer als t2 ist;
- Zeigen (38) des Ergebnisses, wobei der Zustand des Blitzableiters als korrekt, kurzgeschlossen oder falsche Frequenzantwort der ESE-Einrichtung unterschieden wird, und
- Speichern (39) der Daten zur Anzeige zu einem späteren Zeitpunkt.

16. Prüfverfahren nach Anspruch 15, wobei, wenn die Zeitgrenze t3 überschritten wird, ohne Daten empfangen zu haben, ein Fehlersignal (40) generiert wird, welches angibt, dass der Empfänger außerhalb des emittierenden Bereichs der emittierenden Einheit (2) liegt, unzureichende Energie zum Senden von Daten vorhanden ist oder eine Beeinträchtigung aus irgendeinem anderen Grund vorliegt.

17. Prüfverfahren nach Anspruch 15, wobei, wenn die Zeitgrenze t3 nicht überschritten ist und das empfangene Signal korrekt ist, das gezeigte Ergebnis (38) unterscheidet, ob der Blitzableiter korrekt oder kurzgeschlossen ist, oder ob er eine falsche Frequenzantwort der ESE-Einrichtung aufweist.

18. Prüfverfahren nach Anspruch 15, wobei, wenn die Zeitgrenze t3 nicht überschritten ist und das empfangene Signal nicht korrekt ist, die Identifizierung möglich ist, ob ein Datenempfangsfehler vorliegt.

## Revendications

1. Appareil de test pour un dispositif d'amorçage d'un parafoudre (1), l'appareil de test comprenant :
- une unité d'émission (2) configurée pour être installée dans un parafoudre (1) incorporant un moyen d'alimentation électrique (4) et un moyen de stockage d'énergie (5), et
- une unité de réception sans fil (3) comprenant une antenne de réception (17), et un démodulateur de signal (18) pour démoduler le signal obtenu par celui-ci,
**caractérisé en ce que** l'unité d'émission (2) comprend en outre un élément de commande et de traitement (10.1) configuré pour générer un ensemble d'impulsions avec un temps présentant une valeur configurable qui attaque le dispositif d'amorçage du parafoudre et également configuré pour activer ledit dispositif d'amorçage et traiter la réponse de fréquence résultante,
un circuit de mesure (6) configuré pour mesurer la réponse de fréquence du dispositif d'amorçage du parafoudre, un module de test (44) configuré pour être activé par l'élément de commande et de traitement (10.1),
un convertisseur analogique-numérique (7) configuré pour convertir le signal analogique obtenu à partir du test réalisé sur le dispositif d'amorçage avant un traitement, un circuit de modulation (8) configuré pour moduler le signal et une antenne de transmission (9) configurée pour transmettre les données traitées modulées précédemment ;
- dans lequel
l'élément de commande et de traitement (10.1) est programmé pour activer le test de dispositif d'amorçage, réalisé par le module de test (44), à chaque intervalle de temps configurable t1, gardant l'unité d'émission (2) dans un état de veille (26) pendant un intervalle de temps configurable t2, dans lequel t2 étant inférieur à t1, et pour activer l'envoi d'un résultat d'un nouveau test à chaque temps t1 et l'envoi du résultat répété du dernier test réalisé à chaque temps t2 ;
- et dans lequel l'unité de réception (3) comprend en outre un moyen d'identification (19) configuré pour identifier les différents états du parafoudre, une mémoire interne adaptée pour permettre un stockage des données de tests successifs réalisés, et un connecteur externe adapté pour extraire lesdites données dans un dispositif de traitement de données.

2. Appareil de test selon la revendication 1, dans lequel les temps t1 et t2 sont configurables par logiciel.

3. Appareil de test selon la revendication 1, dans lequel les temps t1 et t2 sont configurables en configurant la synchronisation des éléments de l'appareil de test.

4. Appareil de test selon l'une quelconque des revendications précédentes, dans lequel l'appareil de test est configuré pour supporter au moins trois impulsions de courant présentant une amplitude de 100 kA avec une onde de 10/350 µs.

5. Appareil de test selon l'une quelconque des revendications précédentes, dans lequel une unité de réception (3) comprend un interrupteur on/off (14), un moyen d'alimentation électrique et de stockage d'énergie (13), un élément de commande et de traitement (10.2), un convertisseur CC-CC (15) optionnel configuré pour réduire la tension du moyen de stockage (13) connecté à l'élément de commande et de traitement (10.2), un disjoncteur (16) et un écran d'affichage de résultat (19.2).

6. Appareil de test selon l'une quelconque des revendications précédentes, dans lequel l'unité de réception (3) permet un affichage de données de test précédentes et comprend un bouton poussoir (12) pour une activation de cette option.

7. Appareil de test selon l'une quelconque des revendications précédentes comprenant en outre un système d'identification configuré pour identifier le parafoudre dans chaque trame de données pour aider avec les tâches de commande, de suivi et de maintenance du parafoudre.

8. Appareil de test selon l'une quelconque des revendications précédentes, dans lequel, en plus d'une analyse de fréquence, l'appareil de test est configuré pour réaliser une analyse temporelle de réponse de circuit pour des signaux transitoires, alternés ou continus, qu'ils soient périodiques ou non.

9. Appareil de test selon l'une quelconque des revendications précédentes, dans lequel l'unité d'émission (2) comprend des éléments de protection (11) configurés pour une protection contre des surtensions dans chaque connexion qui peut recevoir de telles surtensions.

10. Installation d'un parafoudre (1) avec l'appareil de test selon les revendications 1 à 9, dans laquelle l'unité d'émission (2) de l'appareil de test est adaptée pour être agencée dans le parafoudre (1), et l'unité d'émission (2) comprend un boîtier (20) qui est en forme de pyramide tronquée, évasé, en forme de capuchon, cylindrique, sphérique ou présente une quelconque autre forme que des éléments caractéristiques d'un parafoudre présentent, tels qu'une pointe et une tige (45).

11. Installation selon la revendication 10, dans laquelle l'unité d'émission (2) de l'appareil de test est intégrée dans le boîtier du parafoudre (1).

12. Installation selon la revendication 10, dans laquelle l'unité d'émission (2) de l'appareil de test est située en dehors du boîtier du parafoudre (1).

13. Installation selon la revendication 11, dans laquelle le boîtier (20) est connecté à la portion mise à la terre (45) du parafoudre (1), et présente une première ouverture pour émettre le signal et une seconde ouverture pour connecter le circuit de mesure pour une mesure de réponse de fréquence dans l'unité d'émission (2) et le dispositif d'amorçage du parafoudre (1) par un câble (21).

14. Installation selon la revendication 11, dans laquelle la connexion du boîtier (20) de l'unité d'émission (2) comprend une partie (22) configurée pour l'adapter et l'orienter.

15. Procédé de test, utilisant l'appareil de test selon les revendications 1 à 9, pour tester un parafoudre (1) avec un dispositif d'amorçage et pour tester une installation d'un parafoudre selon les revendications 10 à 14, le procédé de test comprenant :
- une activation (23) de l'élément de commande et de traitement (10.1) ;
- un test (24), par l'unité d'émission (2), du dispositif d'amorçage du parafoudre (1) chaque fois qu'un certain intervalle de temps t1 est dépassé, ou si un manque d'alimentation dans le moyen d'alimentation électrique (4) de celui-ci est détecté, ladite unité d'émission (2) étant dans un état de veille (26) pendant certains intervalles de temps t2, t2 étant inférieur à t1 ;
- un envoi (25) de données résultant d'un test et de caractéristiques du parafoudre (1) vers l'unité de réception (3) ;
- un envoi répété (28) desdites données à chaque intervalle de temps t2, lorsque l'état de veille (26) est interrompu, jusqu'à ce qu'une période de temps t1 soit dépassée ;
- une activation (30) de l'unité de réception (3) et une réception de données à travers ladite unité (3) chaque fois que des données de test ou des données répétées sont envoyées, comprenant l'activation (31) d'un compteur de temps d'attente avec une limite de temps configurable t3, t3 étant supérieur à t2 ;
- une indication (38) du résultat, distinguant l'état du parafoudre comme correct, court-circuité, ou une réponse de fréquence incorrecte du dispositif d'amorçage, et ;
- un stockage (39) de données pour un affichage à un moment ultérieur.

16. Procédé de test selon la revendication 15, dans lequel si la limite de temps t3 est dépassée sans recevoir de données, un signal d'erreur (40) est généré, indiquant que le récepteur est en dehors de la portée d'émission de l'unité d'émission (2), qu'il n'y a pas suffisamment d'énergie pour un envoi de données, ou qu'il est défectueux pour toute autre raison.

17. Procédé de test selon la revendication 15, dans lequel si la limite de temps t3 n'est pas dépassée et le signal reçu est correct, le résultat (38) montré distingue si le parafoudre est correct ou court-circuité, ou s'il présente une réponse de fréquence incorrecte du dispositif d'amorçage.

18. Procédé de test selon la revendication 15, dans lequel si la limite de temps t3 n'est pas dépassée et le signal reçu est incorrect, cela permet d'identifier s'il y a une erreur de réception de données.
